Europäisches Patentamt

European Patent Office

Office européen des brevets

(11) Numéro de publication: **0 002 972**
**A1**

## (12) DEMANDE DE BREVET EUROPEEN

(21) Numéro de dépôt: 78400225.5

(22) Date de dépôt: 11.12.78

(51) Int. Cl.²: **H 03 G 3/20, H 04 B 1/12**

(30) Priorité: 16.12.77 FR 7738095

(71) Demandeur: "THOMSON-CSF", 173, boulevard Haussmann, F-75360 Paris Cedex 08 (FR)

(43) Date de publication de la demande: 11.07.79 Bulletin 79/14

(72) Inventeur: **Menant, Christophe, "THOMSON-CSF"** SCPI 173, bld Haussmann, F-75360 Paris Cedex 08 (FR)

(84) Etats contractants désignés: **DE GB IT NL**

(74) Mandataire: **Blaise, Michel et al, "THOMSON-CSF" -** SCPI 173, bld Haussmann, F-75360 Paris Cedex 08 (FR)

(54) **Dispositif amplificateur à dynamique autoadaptative, et récepteur utilisant un tel dispositif.**

(57) La présente invention concerne les amplificateurs adaptés à des amplitudes de signaux d'entrée variables.

Elle consiste en un asservissement du point de fonctionnement de l'étage d'entrée de l'amplificateur concerné à l'amplitude des signaux à amplifier, prélevés soit à l'entrée soit en sortie de cet amplificateur.

Application aux étages d'entrée de récepteurs soumis à des signaux brouilleurs.

1

# DISPOSITIF AMPLIFICATEUR A DYNAMIQUE AUTOADAPTATIVE, ET RÉCEPTEUR UTILISANT UN TEL DISPOSITIF

La présente invention concerne les dispositifs amplificateurs à dynamique autoadaptative et plus particulièrement les dispositifs amplificateurs à faible consommation et faible bruit utilisés dans les étages d'entrée des récepteurs.

Il est bien connu que la réception de signaux faibles dans un champ perturbateur intense créé, par exemple, par l'émetteur local d'une liaison duplex, nécessite des dispositions particulières dans les circuits d'amplification d'entrée des récepteurs afin d'obtenir une linéarité satisfaisante pour les signaux perturbateurs et d'éviter, ainsi, une modulation de leur gain au rythme du brouilleur d'où résulte une baisse de sensibilité du récepteur, accompagnée de transmodulation, et d'un risque d'intermodulation.

Les solutions connues ont pour base commune un amplificateur d'entrée de réception de forte dynamique polarisé en classe A avec un fort courant de repos.

Les défauts ci-dessus sont ainsi éliminés ou fortement réduits, mais au prix d'une forte consommation entrainant un facteur de bruit élevé.

Ces inconvénients sont particulièrement gênants si l'intensité du champ perturbateur n'est importante que pendant une partie du temps d'exploitation des équipements.

La présente invention a pour objet de les pallier.

Le dispositif amplificateur selon l'invention est caractérisé en ce qu'il comporte un dispositif d'asservissement de la tension de polarisation de l'électrode de son étage d'entrée à l'amplitude de crête des signaux reçus qu'il est chargé d'amplifier.

L'invention sera mieux comprise, et d'autres caractéristiques apparaîtront à l'aide de la description ci-après et des dessins s'y rapportant sur lesquels :

- la figure 1 est un schéma de principe d'un mode de réalisation du dispositif selon l'invention ;

- la figure 2 est un schéma de principe d'un autre mode de réalisation du dispositif selon l'invention.

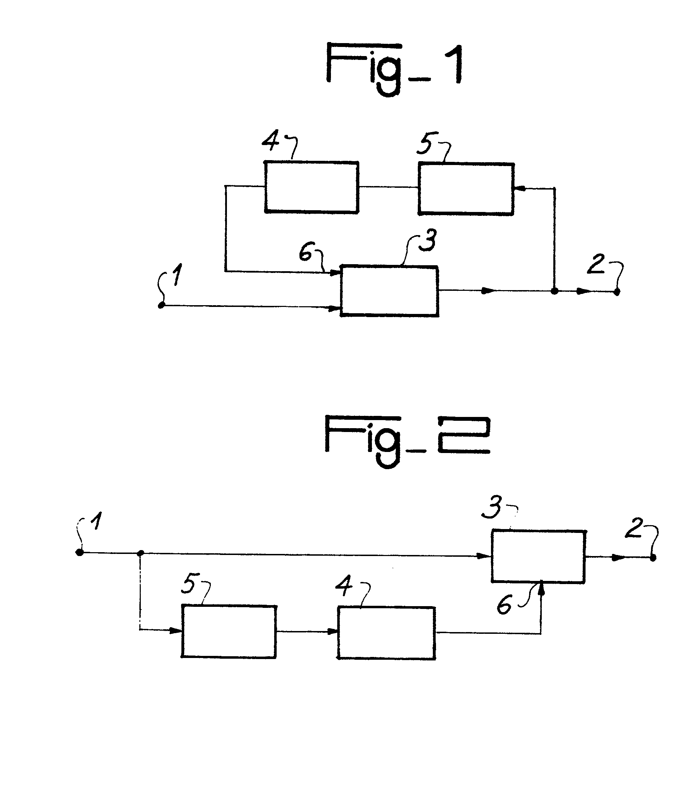

Sur les figures 1 et 2, une borne d'entrée 1 reçoit les signaux à amplifier par un amplificateur 3 ayant une borne de sortie 2 et une entrée de tension de polarisation 6 fournie par un amplificateur 4 précédé d'un détecteur de niveau de crête 5.

Tous ces organes sont identiques sur les deux figures à l'exception de la fonction de transfert de l'amplificateur 4 et du détecteur 5 dont l'entrée est couplée à la borne de sortie 2, dans le cas de la figure 1 et à la borne d'entrée 1, dans le cas de la figure 2.

Dans l'exemple choisi, l'amplificateur 3 est constitué d'un étage à transistors excité à partir de la borne 1, sur sa base, dont la polarisation par rapport à la masse est fixée par la tension appliquée sur la borne 6 de l'amplificateur 3 par l'amplificateur 4.

Soit $V_e$ l'amplitude du signal d'entrée composite tel que :

$$V_e = S(t) + B(t)$$

où $S(t)$ est l'amplitude du signal utile en fonction du temps et $B(t)$ celle du signal brouilleur.

Soit $G$ le gain de l'amplificateur 3 qui délivre donc un signal $G\,V_e$ sur la borne 2.

La tension de polarisation $V$ appliquée sur la borne 6 comporte une partie constante $V_o$ correspondant au point de polarisation de l'amplificateur 3 , soit au repos soit pour des signaux d'entrée dont l'amplitude de crête $\overline{V}_e$ est inférieure à $V_o$ .

Pour des amplitudes supérieures, l'amplificateur 3 restera linéaire pour une tension de polarisation globale $V_T = V_o + U \gg \overline{V}_e$

$U$ étant la polarisation supplémentaire à fournir par l'amplificateur 4.

Dans le cas de la figure 1 , cette tension est élaborée à partir du signal $G\,V_e$ délivré par l'amplificateur 3 qui devient $f(G\,\overline{V}_e)$, en réponse à la fonction de transfert du détecteur de crête 5 et de l'amplificateur 4 d'où

$$V_o + f(\overline{G\,V_e}) \gg \overline{V}_e$$

ou $f(\overline{G\,V_e}) \gg \overline{V}_e - V_o$

qui peut s'écrire, si l'amplificateur 4 est linéaire,

$$f(\overline{V}_e) \gg \frac{\overline{V}_e - V_o}{G}$$

Dans le cas de la figure 2, on a $G = 1$ donc

$$f(\overline{V}_e) \gg \overline{V}_e - V_o$$

Il est ainsi obtenu, dans l'un ou l'autre cas, des conditions optimales de fonctionnement de l'amplificateur, à savoir un point de fonctionnement variable, et donc une dynamique et une consommation adaptées au niveau d'entrée global auquel est soumis l'amplificateur.

4

En particulier, dans le cas de l'utilisation d'un tel dispositif à l'entrée des récepteurs dont les signaux utiles reçus sont toujours faibles, une faible consommation alliée à un facteur de bruit minimal est assurée en l'absence de brouilleurs.

La dynamique et la consommation s'adaptent automatiquement au niveau du signal brouilleur présent pour maintenir de bonnes conditions de linéarité de l'amplificateur 3.

## REVENDICATIONS

1. Dispositif amplificateur comportant un amplificateur de signaux en classe A (3) ayant une entrée (6) destinée à recevoir une tension de polarisation de l'électrode de l'étage d'entrée sur laquelle sont appliqués les signaux à amplifier, caractérisé en ce qu'il comporte en outre un étage détecteur de crête (5) ayant une entrée et étant suivi d'un amplificateur auxiliaire (4) dont le signal de sortie constitue cette tension de polarisation.

2. Dispositif selon la revendication 1, caractérisé en ce que l'entrée de l'étage détecteur est couplée à la sortie (2) de l'amplificateur de signaux.

3. Dispositif selon la revendication 1, caractérisé en ce que l'entrée de l'étage détecteur est couplée à l'entrée (1) de l'amplificateur de signaux.

4. Récepteur caractérisé en ce qu'il comporte comme étage d'entrée un dispositif amplificateur selon l'une des revendications précédentes.

0002972

1/1

Fig_1

Fig_2

Office européen
des brevets

| DOCUMENTS CONSIDERES COMME PERTINENTS | | | CLASSEMENT DE LA DEMANDE (Int. Cl.²) |
|---|---|---|---|
| Catégorie | Citation du document avec indication, en cas de besoin, des parties pertinentes | Revendica-tion concernée | |
| X | <u>DE - B - 1 118 261</u> (PHILIPS)<br>  * De colonne 1, ligne 51 - colonne 2, ligne 40 et de colonne 3, ligne 35 - colonne 4, ligne 5 *<br><br>-- | 1-3 | **H 03 G 3/20<br>H 04 B 1/12** |
| X | <u>DE - B - 1 297 703</u> (ROHDE et SCHWARZ)<br>  * Colonne 2, lignes 18-50 *<br><br>-- | 1,3 | |
| | <u>DE - B - 1 512 948</u> (SIEMENS)<br>  * Colonne 3, lignes 45-55 *<br><br>-- | 1,2,4 | **DOMAINES TECHNIQUES RECHERCHES (Int. Cl.²)**<br><br>H 03 G<br>H 03 F<br>H 04 B |
| | <u>FR - A - 2 156 804</u> (SONY)<br>  * Figure 5; de page 5, ligne 22-page 6, ligne 19 *<br><br>-- | 1,2,4 | |
| | <u>GB - A - 875 063</u> (POST OFFICE)<br>  * Figures 1,2; page 3, lignes 58-100 *<br><br>-- | 1,3,4 | |
| | RADIO MENTOR, vol. 24, no. 8, août 1958<br>München, DE<br>WAGNER: "Zur Technik der Sellest-tätigen Amplitudenregelung in Empfängern", pages 525-532.<br>  * Page 8, sous le chapitre "Regelschaltungen" les alinéas 1,2,3 et 6 et figures 4a-4c,5a,5b *<br><br>-- ./. | 1-4 | **CATEGORIE DES DOCUMENTS CITES**<br><br>X: particulièrement pertinent<br>A: arrière-plan technologique<br>O: divulgation non-écrite<br>P: document intercalaire<br>T: théorie ou principe à la base de l'invention<br>E: demande faisant interférence<br>D: document cité dans la demande<br>L: document cité pour d'autres raisons<br><br>&: membre de la même famille, document correspondant |

| X | Le présent rapport de recherche a été établi pour toutes les revendications | | |
|---|---|---|---|
| **Lieu de la recherche**<br>La Haye | **Date d'achèvement de la recherche**<br>14-03-1979 | **Examinateur**<br>THOMAES | |

OEB Form 1503.1   06.78

Office européen
des brevets

| Catégorie | Citation du document avec indication, en cas de besoin, des parties pertinentes | Revendication concernée |
|---|---|---|
| | **DOCUMENTS CONSIDERES COMME PERTINENTS** | |
| | FR - A - 1 014 949 (KULKA)  * De page 1, colonne de droite, ligne 9 - page 2, ligne 5, et page 2, colonne de gauche, lignes 34-37 *  -- | 1,2 |
| A | ELECTRONICS, vol. 50, no. 7, 31 mars 1977, New York USA HECKT: "Automatic gain control has 60-decibel range", page 107.  * Alinéas 1 et 2 * | 1,2 |

**CLASSEMENT DE LA DEMANDE (Int. Cl.²)**

**DOMAINES TECHNIQUES RECHERCHES (Int. Cl.²)**